# EUROPÄISCHE PATENTSCHRIFT

(11) **EP 1 743 510 B1**
(45) Veröffentlichungstag und Bekanntmachung des Hinweises auf die Patenterteilung: **28.11.2012**
(21) Anmeldenummer: 05732047.5
(22) Anmeldetag: 16.04.2005
(51) Int. Cl.: H05K 3/04

(54) **VERFAHREN ZUM DRUCKEN ELEKTRISCHER UND/ODER ELEKTRONISCHER STRUKTUREN UND FOLIE ZUR VERWENDUNG IN EINEM SOLCHEN VERFAHREN**
METHOD FOR PRINTING ELECTRICAL AND/OR ELECTRONIC STRUCTURES AND FILM FOR USE IN SUCH A METHOD
PROCEDE POUR IMPRIMER DES STRUCTURES ELECTRIQUES ET/OU ELECTRONIQUES ET FEUILLE A UTILISER DANS CE PROCEDE

(30) Priorität: 19.04.2004 DE 102004019412
(43) Veröffentlichungstag der Anmeldung: 17.01.2007
(73) Patentinhaber: manroland sheetfed GmbH, 63075 Offenbach (DE)
(72) Erfinder: WALTHER, Thomas, 63067 Offenbach (DE)
(74) Vertreter: Stahl, Dietmar
(86) Internationale Anmeldenummer: PCT/EP2005/004061
(87) Internationale Veröffentlichungsnummer: WO 2005/101930

(56) Entgegenhaltungen:
- EP-A- 0 148 601
- EP-A- 0 414 362
- US-A- 4 465 538
- US-A- 5 250 758

## Beschreibung

Die Erfindung betrifft ein Verfahren zum Drucken elektrischer und/oder elektronischer Strukturen, insbesondere elektrischer Leiterbahnen und/oder elektronischer Schaltungen, nach dem Oberbegriff des Patentanspruchs 1.

Es sind verschiedene Verfahren bekannt, Teile elektrischer bzw. elektronischer Schaltungen oder die gesamte Schaltung durch drucktechnische Verfahren, z. B. im Offsetdruck, auf ein Trägersubstrat bzw. einen Bedruckstoff zu übertragen. Im Offsetdruck lassen sich sehr kleine Elemente darstellen, sodass dieses Verfahren prädestiniert ist, Bestandteile oder eine komplette elektronische Schaltung herzustellen. Dies ist im allgemeinen aus lithographischen Verfahren zur Schaltungsherstellung bekannt.

Andere Verfahren sind aus EP-A-0 414 362, US-A-5 250 758 und EP-A- 0 148 601 bekannt.

Der Offsetdruck hat darüber hinaus den prinzipiellen Vorteil gegenüber anderen Druckverfahren, wie z.B. dem Ink-Jet-Druck, dass mit der permanenten Druckform des Offsetdrucks eine vergleichsweise hohe Produktivität erreicht werden kann und durch eine Optimierung des Bebilderungsprozesses sehr hohe Strukturfeinheiten erreicht werden können.

Der wesentliche Vorteil des Offsetdrucks ist jedoch, dass Verpackungen, die ein elektronisches Bauteil wie z.B. ein RFID-Etikett aufweisen, in einem Arbeitsschritt gefertigt werden können. In den ersten Druckwerken einer Offsetdruckmaschine können z.B. Bestandteile eines RFID-Etiketts direkt auf die Verpackung gedruckt werden und in den restlichen Druckwerken der Rest der Verpackung fertig gestellt werden.

Im Offsetdruck unterscheidet man prinzipiell drei verschiedene Applikationsverfahren: Den Nassoffsetdruck, den wasserlosen Offsetdruck, auch unter dem Begriff Toray-Verfahren bekannt, und den Trockenoffsetdruck, auch Letter-Set-Verfahren genannt. Bei dem letztgenannten Verfahren handelt es sich streng genommen um ein Hochdruckverfahren, da an Stelle der Offsetdruckplatte eine Hochdruckplatte eingespannt wird. Allen Verfahren ist gemeinsames Merkmal, dass von der Druckform (Flachdruckplatte) über ein Gummituch als Zwischenträger das Druckbild auf den Bedruckstoff übertragen wird.

Im Gegensatz zu den klassischen Drucksujets kommt es beim Drucken von elektronischen Schaltungen nicht auf eine gute visuelle Wiedergabe, sondern auf die Einhaltung von elektro-physikalischen Anforderungen an. So ist z. B. der Widerstand einer Leiterbahn nicht nur von den Materialeigenschaften des applizierten leitfähigen Materials abhängig, sondern auch von der Geometrie des Leitungsquerschnittes. Die dünnste Stelle der Leiterbahn definiert den wirksamen elektrischen Widerstand. Für eine reproduzierbare, definierte elektrische Funktion ist somit eine möglichst gleichmäßige, homogene Applikation der leitfähigen Druckfarbe notwendig.

Betrachtet man nun die verschiedenen Verfahren des Offsetdrucks, so haben sie alle Schwächen, die entweder in der erreichbaren Auflösung oder in der ungenügenden Homogenität der Applikation der leitfähigen Farbe liegen.

Im Nassoffsetdruck liegt das Problem vor, dass das Feuchtmittel zu einem gewissen Teil in die Offsetfarbe hinein emulgiert wird und zu einem gewissen Anteil als freies Oberflächenwasser vorliegt. Wird diese Druckfarbe-Feuchtmittel-Emulsion nun auf den Bedruckstoff übertragen, kann eine inhomogene Verteilung des Feuchtmittels zu Störungen in der Farbübertragung führen. Dies kann zu Fehlstellen in Leiterbahnen und damit verbunden zu Veränderung der elektro-physikalischen Eigenschaften des Druckes führen.

Das Verfahren des wasserlosen Offsetdruckes (Toray-Verfahren) bietet gegenüber dem Nassoffset einen deutlich geschlosseneren Flächendruck und wäre daher für die Applikation von elektrisch leitfähigen Leiterbahnen besser geeignet. Der Nachteil bei diesem Verfahren ist jedoch, dass die Farbe für die Trennung zwischen Bild- und Nichtbildstellen einen gewissen Anteil an Silikonöl enthalten muss. Dieses Silikonöl stellt aber andererseits als Werkstoff einen hervorragender Isolator dar und kann daher die Leitfähigkeit von Leiterbahnen mehr oder weniger unkontrollierbar beeinträchtigen.

Das Verfahren des Trockenoffset mit Letter-Set-Platten hat zwar den Vorteil, dass höhere Schichtdicken als im Nassoffset übertragen werden können, nachteilig ist aber die vergleichsweise geringe Auflösung der Bildelemente bei dieser Art von Druckplatten. Dennoch ist der indirekte Druck mit Trockenoffsetplatten, zu mindestens für einfach gestaltete Schaltungsaufbauten, ein geeignetes Arbeitsverfahren um leitfähige Strukturen indirekt, über das zwischengeschaltete Gummituch, auf einen Bedruckstoff zu übertragen.

In diesem Zusammenhang sind noch weitere Nachteile des Offsetdruckverfahrens für die Applikation von Leiterbahnen zu nennen, da die relativ dünnen Schichten, die im Offsetdruck appliziert werden können (maximal 3µm), für Schichten der geforderten Art häufig grenzwertig sind. Dies erzeugt einen relativ hohen Durchgangswiderstand. Außerdem weist die Qualität der Schichten eine hohe Anfälligkeit für drucktechnische Störungen auf. Auch das Wegschlagen der Druckfarbe in den Bedruckstoff kann zu Veränderungen der elektro-physikalischen Eigenschaften führen.

Dennoch ist das Drucken von leitfähigen Strukturen mit in geeigneter Weise mit leitfähigen Bestandteilen modifizierten Bogenoffsetfarben möglich, die Leitfähigkeit leidet aber darunter, dass Pigmente oder leitfähige Strukturen in einem Bindemittel gebunden sind. Pigmente und Bindemittel werden bei der Produktion der Bogenoffsetfarben so lange verrieben, bis die einzelnen Pigmenten möglichst optimal mit Bindemittel vernetzt sind und untereinander keinen oder kaum direkten Kontakt haben. Dies hat zur Folge, dass metallische Pigmente, die in einem unmodifizierten Bindemittel verrieben werden, gedruckt nicht zwangsläufig eine gut leitende Struktur ergeben müssen.

Hiervon ausgehend liegt der vorliegenden Erfindung die Aufgabe zu Grunde, ein neuartiges Verfahren zum Drucken elektrischer und/oder elektronischer Strukturen, insbesondere elektrischer Leiterbahnen und/oder elektronischer Schaltungen, zu schaffen.

Diese Aufgabe wird durch ein Verfahren gemäß Patentanspruch 1 gelöst. Im Sinne der Erfindung wird in mindestens einem ersten Druckwerk ein Sujet der zu druckenden elektrischen und/oder elektronischen Struktur mit einem Kleber auf den Bedruckstoff aufgetragen, wobei der mit dem Klebstoff partiell bedruckte Bedruckstoff mindestens einem zweiten Druckwerk zugeführt wird, in welchem auf die mit Klebstoff bedruckten Bereiche des Bedruckstoffs ein leitfähiges Material aufgetragen wird.

Bevorzugte Weiterbildungen der Erfindung ergeben sich aus den Unteransprüchen und der nachfolgenden Beschreibung.

Ausführungsbeispiele der Erfindung werden, ohne hierauf beschränkt zu sein, an Hand der Zeichnung näher erläutert. Dabei zeigt:

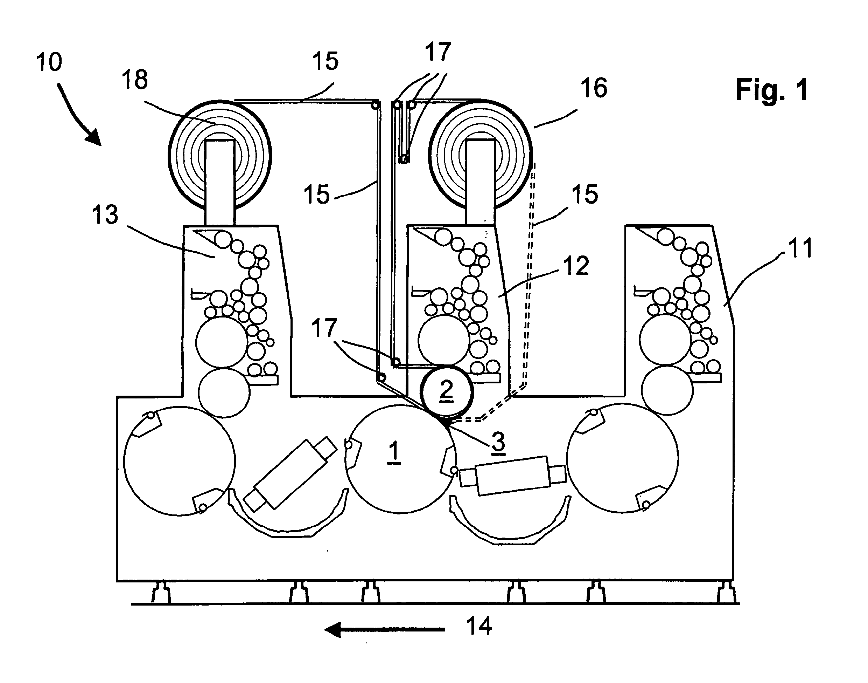

- Fig. 1:: einen Ausschnitt aus einer Druckmaschine zur Verdeutlichung des erfindungsgemäßen Verfahrens zum Drucken elektrischer und/oder elektronischer Strukturen, insbesondere elektrischer Leiterbahnen und/oder elektronischer Schaltungen.

Nachfolgend wird die hier vorliegende Erfindung unter Bezugnahme auf Fig. 1 in größerem Detail beschrieben.

Fig. 1 zeigt einen Ausschnitt aus einer Druckmaschine 10 im Bereich von drei hintereinander angeordneten Druckwerken 11, 12 und 13, wobei ein zu bedrukkender Bedruckstoff in Richtung des Pfeils 14 durch die Druckwerke 11, 12 und 13 bewegt wird. Mit dem hier vorliegenden erfindungsgemäßen Verfahren soll eine elektronische bzw. elektrische Struktur auf den Bedruckstoff aufgetragen werden.

Im Sinne der hier vorliegende Erfindung wird vorgeschlagen, in mindestens einem ersten Druckwerk, im Ausführungsbeispiel der Fig. 1 im Druckwerk 11, ein Sujet der zu druckenden, elektrischen und/oder elektronischen Struktur mit einem Kleber auf den Bedruckstoff aufzutragen.

Darauf folgend wird der mit Klebstoff partiell bedruckte Bedruckstoff mindestens einem zweiten Druckwerk, im Ausführungsbeispiel der Fig. 1 dem Druckwerk 12, zugeführt. In diesem zweiten Druckwerk 12 wird dann auf die im Druckwerk 11 mit Klebstoff bedruckten Bereiche des Bedruckstoffs ein leitfähiges Material aufgetragen.

Im Sinne der hier vorliegenden Erfindung wird der Klebstoff im ersten Druckwerk 11 vorzugsweise im Offsetdruck aufgetragen. In diesem Fall ist das erste Druckwerk 11 als Offsetdruckwerk ausgebildet. Alternativ hierzu ist es auch möglich, dass das erste Druckwerk 11 als direktes oder indirektes Hochdruckwerk ausgebildet ist, um so den Klebstoff im direkten oder indirekten Hochdruck auf den Bedruckstoff aufzutragen.

Wie in Fig. 1 dargestellt, wird nach einer besonders bevorzugten Ausführungsform der hier vorliegenden Erfindung der mit dem Klebstoff partiell bedruckte Bedruckstoff in dem zweiten Druckwerk 12 einer Folie 15 zugeführt. Die Folie 15 trägt eine abnehmbare Schicht eines elektrisch leitfähigen bzw. eines elektrisch halbleitfähigen Materiales, welches von der Folie 15 auf die mit Klebstoff bedruckten Bereiche des Bedruckstoffs übertragen wird. Wie Fig. 1 entnommen werden kann, wird die Folie 15 von einer ersten Trommel bzw. Vorratsrolle 16 abgewickelt und über gff. mehrere Umlenkwalzen 17 dem Druckwerk 12 zugeführt. Die Umlenkwalzen 17 können sogenannte Tänzerwalzen zur Aufrechterhaltung einer ausreichenden Bahnspannung der Folie 15 beinhalten.

Das Druckwerk 12 weist wenigstens einen Gegendruckzylinder 1 und eine Presswalze 2 auf. Die Presswalze 2 entspricht vorzugsweise dem Drucktuchzylinder eines Offsetdruckwerkes oder dem Formzylinder eines Lackmodules. Die Folie 15 wird in der gezeigten Weise um die Presswalze 2 herum oder in etwa tangential an der Presswalze 2 vorbei durch einen Transferspalt 3 zwischen der Presswalze 2 und dem Gegendruckzylinder 1 geführt. Hierbei wird die Folie 15 mit der beschichteten Seite auf den Bedruckstoff aufgelegt und mit diesem gemeinsam unter Druck durch den Transferspalt 3 geführt. Dabei erfolgt eine Übertragung der Beschichtung bzw. des leitfähigen Materials der Folie 15 im Bereich des Klebersujets auf den Bedruckstoff. Nach dem Übertragen des leitfähigen Materials auf die mit Klebstoff bedruckten Bereiche des Bedruckstoffs wird die Folie 15 auf einer Trommel bzw. Wickelrolle 18 aufgewickelt.

Auf der Vorratsrolle 16 liegt demnach eine vollständig bzw. komplett mit leitfähigem Material beschichtete Folie vor, wohingegen auf der Wickelrolle 18 das leitfähige Material bereichsweise von der Folie 15 auf den Bedruckstoff übertragen wurde. Bei der auf der Wickelrolle 18 aufgewickelten Folie handelt es sich demnach um verbrauchte Folie mit einer unvollständigen Schicht des leitfähigen bzw. halbleitfähigen Materiales.

Wenn die Folie 15 beispielsweise mit einer Aluminiumschicht oder einer andersartigen Schicht eines leitfähigen Materials beschichtet ist, werden aus dieser Schicht durch die Übertragung im Transferspalt 3 auf den Bedruckstoff Teile entnommen. Die restliche Beschichtung verbleibt auf der Folie 15.

Es liegt nun ebenfalls im Sinne der hier vorliegenden Erfindung, die verbrauchte Folie 15 im Anschluss an das Übertragen des leitfähigen Materials auf die mit Klebstoff bedruckten Bereiche des Bedruckstoffs mit leitfähigen Material neu zu beschichten. Dies kann zum Beispiel durch elektrostatische Beschichtung oder durch Bestäuben oder durch Bepudern oder auch durch Besprühen erfolgen.

Als weitere Möglichkeit der Beschichtung wäre also auch eine umlaufende endlose Folie vorstellbar, die immer wieder neu mit einer leitfähigen Substanz beschichtet wird, z.B. durch ein Rakelsystem oder durch eine elektrostatische Beschichtung. Dies könnte z.B. dadurch erfolgen, dass eine elektrisch geladene Folie immer wieder mit gegenüber der Folie gegensätzlich geladenen, leitfähigen Russen berieselt wird und überschüssiges Material durch Vibration, durch eine Rakel, durch eine Bürste oder eine anders geartete Vorrichtung entfernt wird.

Auch ist es möglich, zum Auffrischen der Beschichtung der verbrauchten Folie die leitfähige Substanz in flüssiger Form aufzutragen, wobei dieser Auftrag mittels eines Kammerrakelsystems, einer Sprühvorrichtung oder einem Walzenwerk erfolgen kann. Überschüssige Beschichtung wird nach dem Beschichten durch ein Rakelsystem, eine Luftrakel oder ein Walzensystem entfernt. Nachdem also ein homogener Film der Beschichtung auf dem Band oder Zylinder vorliegt, wird die Beschichtung mittels einer Trocknungseinrichtung mit dem Ziel getrocknet, eine möglichst lösemittelfreie, durch nicht leitende Substanzen wenig oder nicht mehr kontaminierte Beschichtung zu erhalten.

Weiterhin ist es auch möglich - ohne anschließende Trocknung - auf einer Folie eine definierte Schichtdicke einer leitfähigen Substanz dadurch zu erzeugen, dass die leitfähige Substanz per Laserimpuls auf den Bedruckstoff übertragen wird.

Im Anschluss an das Auftragen des leitfähigen Materials auf die mit Klebstoff bedruckten Bereiche des Bedruckstoffs kann der Bedruckstoff einem Druckwerk 13 zugeführt werden. Im Druckwerk 13 kann eine Nachbearbeitung derart erfolgen, dass eine sich beim Übertragen des leitfähigen Materials auf die mit Klebstoff bedruckten Bereiche des Bedruckstoffs einstellende Schichtdicke auf ein definiertes Maß eingestellt wird. Dies kann zum Beispiel über eine Rakeleinrichtung mit positiver oder negativer Rakeistellung oder durch ein Kalandrierwerk oder durch eine Luftrakel erfolgen. Auch kann der mit elektrisch leitfähigem Material beschichtete Bedruckstoff im Druckwerk 13 einer Pressung oder Glättung unterzogen werden. Auch hierdurch kann die Schichtdicke des leitfähigen Materials auf ein definiertes Maß eingestellt werden.

Im Unterschied zum Ausführungsbeispiel der Fig. 1 kann an Stelle mit der Folie 15 das elektrisch leitfähige Material auf die im ersten Druckwerk 11 mit Klebstoff bedruckten Bereiche des Bedruckstoffs auch mit Hilfe eines Zylinders aufgetragen werden. In diesem Fall wird der Bedruckstoff in dem zweiten Druckwerk 12 einem Zylinder zugeführt, von dem auf die mit Klebstoff bedruckten Bereiche des Bedruckstoffs ein leitfähiges Material übertragen wird. Dieser Zylinder kann die Presswalze 2 sein.

Ähnlich könnte auch ein geladener Zylinder eingesetzt werden, der immer wieder mit einer gegensätzlich geladenen, elektrisch leitfähigen oder halbleitfähigen Substanz berieselt wird. Diese Substanz wird nur an den Stellen auf den Bedruckstoff übertragen, an welchen der Kleber auf den Bedruckstoff aufgebracht ist.

Im Zusammenhang mit dem in Fig. 1 gezeigten Ausführungsbeispiel der hier vorliegenden Erfindung wird eine Folie 15 zum Übertragen des leitfähigen Materials auf die mit Klebstoff bedruckten Bereiche des Bedruckstoffs verwendet. Die Folie 15 verfügt über einen mindestens zweilagigen bzw. zweischichtigen Aufbau aus einer Trägerfolie und einer elektrisch leitfähigen Funktionsschicht. Die elektrisch leitfähige Funktionsschicht kann dabei unmittelbar auf die Trägerfolie aufgebracht sein. Bevorzugt ist jedoch eine Ausführungsform der Folie 15, in welcher dieselbe einen dreischichtigen bzw. dreilagigen Aufbau aufweist. Bei einem derartigen dreischichtigen bzw. dreilagigen Aufbau ist zwischen der Trägerfolie und der elektrisch leitfähigen Funktionsschicht eine Trennschicht bzw. Haftvermittlungsschicht positioniert.

Die Trägerfolie und/oder die Trennschicht ist als eine niederenergetische Folie bzw. Schicht mit einer Oberflächenenergie von vorzugsweise weniger als 35 mNm ausgebildet, sodass eine geringe Haftung der elektrisch leitfähigen Funktionsschicht gegeben ist. Die elektrisch leitfähige Funktionsschicht löst sich demnach leicht von der Trägerfolie bzw. der Trennschicht ab und kann so mit vergleichsweise geringem Kraft- bzw. Druckaufwand auf die mit Klebstoff beschichteten Bereiche des Bedruckstoffs übertragen werden.

Die elektrisch leitfähige Funktionsschicht ist mit der Trägerfolie mit oder ohne dazwischen positionierter Trennschicht vorzugsweise durch Laminierung verbunden. Alternativ ist es möglich, dass die elektrisch leitfähige Funktionsschicht mit der Trägerfolie unmittelbar durch Adhäsion oder durch elektrische Ladungskräfte bzw. durch elektrostatische Haftung verbunden ist.

Die elektrisch leitfähige Funktionsschicht ist vorzugsweise als überwiegend metallische Schicht ausgebildet. Sie kann zum Beispiel durch hochleitfähige Ruße gebildet werden. Alternativ ist es möglich, dass die elektrisch leitfähige Funktionsschicht als eine Beschichtung aus intristischen Funktionspolymeren ausgebildet ist. Typische Funktionspolymere können Polythiophene, Polypyrrole, Polyaniline, Polyethylen-Dioxythiophene u.a. sein.

Im Sinne der hier vorliegenden Erfindung wird demnach ein Verfahren zum Drukken elektrischer und/oder elektronischer Strukturen vorgeschlagen, welches die Vorteile der sehr hohen Auflösung des Offsetdrucks nutzt und welches gleichzeitig sehr hohe und homogene Schichtdicken auf den Bedruckstoff überträgt. Dies wird erreicht, indem in einem oder mehreren Druckwerken 11 die Struktur der elektrischen Komponente mittels eines Klebers auf den Bedruckstoff aufgebracht wird. Der mit einem der elektrischen Struktur entsprechenden Sujet bedruckte Bedruckstoff wird in einem nächsten Arbeitsschritt in einem oder mehreren Druckwerken 12 vorzugsweise mit einer Transferfolie (Folie 15) in Kontakt gebracht, die mit einer leitfähigen Beschichtung versehen ist. Von der Folie 15 wird die leitfähige Beschichtung auf die mit Klebstoff bedruckten Bereiche des Bedruckstoffs übertragen. Die leitfähige Beschichtung kann z.B. metallischer Art sein, aus leitfähigen Russen oder aus Funktionspolymeren bestehen.

Das dieser Art beschriebene Beschichtungsverfahren kann inline in Druckeinheiten einer Offsetdruckmaschine oder in die Offsetdruckmaschine integrierten Arbeitseinheiten, wie Lackmodulen, erfolgen.

### Bezugszeichenliste

- 1: Gegendruckzylinder
- 2: Presswalze
- 3: Transferspalt
- 10: Druckmaschine
- 11: Druckwerk
- 12: Druckwerk
- 13: Druckwerk
- 14: Pfeil
- 15: Folie
- 16: Trommel, Vorratsrolle
- 17: Umlenkwalze
- 18: Trommel, Wickelrolle

## Patentansprüche

1. Verfahren zum Drucken elektrischer und/oder elektronischer Strukturen, als elektrischer Leiterbahnen oder elektronischer Schaltungen, auf einen Bedruckstoff, wobei auf den Bedruckstoff eine Klebstoffschicht in Form der zu erzeugenden elektrischen Leiterbahnen oder elektronischen Schaltungen aufgebracht wird und wobei weiterhin von einer Folie (15) auf die Klebstoffschicht eine elektrisch leitende Schicht übertragen wird,
**dadurch gekennzeichnet,**
- **dass** der Bedruckstoff zum Übertragen der elektrisch leitenden Schicht durch mehrere hintereinander angeordnete Druckwerke einer Bogendruckmaschine bewegt wird,
- **dass** in einem ersten Druckwerk (11), das als Offsetdruckwerk oder Lackmodul einer Offsetdruckmaschine ausgebildet ist, ein Sujet der zu druckenden elektrischen und/oder elektronischen Struktur mit einem Kleber im Verfahren des Offsetdrucks auf den Bedruckstoff aufgetragen wird,
- und **dass** der mit dem Klebstoff partiell bedruckte Bedruckstoff in mindestens einem zweiten Druckwerk (12) einem Transferspalt (3) zugeführt wird, wobei das Druckwerk (12) als Offsetdruckwerk mit wenigstens einem Drucktuchzylinder und einem Gegendruckzylinder (1) ausgebildet ist oder als Lackmodul einer Offsetdruckmaschine ausgebildet ist, und wobei der Transferspalt (3) von einer durch den Drucktuchzylinder gebildeten Presswalze (2) und dem
Gegendruckzylinder (1) gebildet wird,
- und **dass** in dem Transferspalt (3) die Folie (15) auf den Bedruckstoff aufgelegt und mit diesen gemeinsam unter Druck durch den Transferspalt geführt wird, wobei von der Folie auf die mit Klebstoff bedruckten Bereiche des Bedruckstoffs ein leitfähiges Material übertragen wird.

2. Verfahren nach Anspruch 1,
**dadurch gekennzeichnet,**
**dass** der Klebstoff zur Erzeugung des Sujets der elektrischen und/oder elektronischen Struktur in mindestens einem als direktes oder indirektes Hochdruckwerk ausgebildeten Lackmodul auf den Bedruckstoff aufgetragen wird.

3. Verfahren nach Anspruch 1,
**dadurch gekennzeichnet,**
**dass** die metallische Schicht zur Erzeugung des Sujets der elektrischen und/oder elektronischen Struktur von der Folie (5) auf den Bedruckstoff in mindestens einem als direktes oder indirektes Hochdruckwerk ausgebildeten Lackmodul auf den Bedruckstoff aufgetragen wird.

## Claims

1. A method for the printing of electrical and/or electronic structures as electrical conductor tracks or electronic circuits on a substrate, wherein an adhesive layer in the form of conductor tracks or electronic circuits to be created is applied onto the substrate and wherein furthermore from a film (15) an electrically conductive layer is transferred onto the adhesive layer, **characterized**
- **in that** the substrate for transferring the electrically conductive layer is moved through a plurality of printing couples of a sheet-fed printing press arranged one after the other,
- **in that** in a first printing couple (11), which is designed as offset printing couple or varnish module of an offset printing press, a subject of the electrical and/or electronic structure to be printed is applied onto the substrate with an adhesive by the offset printing method,
- and **in that** the substrate partially printed with the adhesive is fed to a transfer gap (3) in at least one second printing couple (12), wherein the printing couple (12) is designed as offset printing couple with at least one blanket cylinder and an impression cylinder (1) or is designed as varnish module of an offset printing press, and wherein the transfer gap (3) is formed by a press roller (2) formed by the blanket cylinder and the impression cylinder (1),
- and **in that** in the transfer gap (3) the film (15) is placed onto the substrate and jointly with the latter is guided through the transfer gap under pressure, wherein from the film a conductive material is transferred onto the regions of the substrate printed with adhesive.

2. The method according to Claim 1,
**characterized**
**in that** the adhesive for creating the subject of the electrical and/or electronic structure is applied onto the substrate in at least one varnish module designed as direct or indirect letterpress couple.

3. The method according to Claim 1,
**characterized**
**in that** the metallic layer for creating the subject of the electrical and/or electronic structure is applied onto the substrate from the film (15) onto the substrate in at least one varnish module designed as direct or indirect letterpress couple.

## Revendications

1. Procédé d'impression de structures électriques et/ou électroniques, sous forme de circuits imprimés électriques ou de circuits électroniques, sur un support d'impression, une couche de colle ayant la forme des circuits imprimés électriques ou circuits électroniques à créer étant appliquée sur le support d'impression et une couche conductrice d'électricité étant en outre transférée d'une feuille (15) sur la couche de colle,
**caractérisé en ce que**
- le support d'impression, pour le transfert de la couche conductrice d'électricité, est déplacé dans plusieurs unités d'impression disposées successivement d'une machine d'impression de feuilles,
- dans une première unité d'impression (11) qui se présente sous forme d'une unité d'impression offset ou d'un module de vernissage d'une machine d'impression offset, un motif de la structure électrique et/ou électronique à imprimer est apposé sur le support d'impression avec une colle dans le procédé d'impression offset
- et que le support d'impression imprimé partiellement de colle est acheminé dans au moins une seconde unité d'impression (12) vers un intervalle de transfert (3), l'unité d'impression (12) se présentant sous forme d'une unité d'impression offset comportant au moins un cylindre porte-blanchet et un cylindre de contre-pression (1) ou sous forme d'un module de vernissage d'une machine d'impression offset et l'intervalle de transfert (3) étant constitué d'un rouleau compresseur (2) formé par le cylindre porte-blanchet et le cylindre de contre-pression (1)
- et que, dans l'intervalle de transfert (3), la feuille (15) est posée sur le support d'impression et conduite en commun avec celui-ci sous pression dans l'intervalle de transfert, un matériau conducteur d'électricité étant transféré de la feuille sur les zones imprimées de colle du support d'impression.

2. Procédé selon la revendication 1,
**caractérisé en ce que**
la colle, pour créer le motif de la structure électrique et/ou électronique, est appliquée sur le support d'impression dans au moins un module de vernissage réalisé sous forme d'une unité à haute pression directe ou indirecte.

3. Procédé selon la revendication 1,
**caractérisé en ce que**
la couche métallique, pour créer le motif de la structure électrique et/ou électronique, est appliquée depuis la feuille (15) sur le support d'impression dans au moins un module de vernissage réalisé sous forme d'une unité à haute pression directe ou indirecte.
